# FASCICULE DE BREVET EUROPEEN

(11) **EP 0 686 977 B1**
(45) Date de publication et mention de la délivrance du brevet: **21.01.1998**
(21) Numéro de dépôt: 95470019.1
(22) Date de dépôt: 12.05.1995
(51) Int. Cl.: G11C 19/00, G06F 11/26

(54) **Cellule pour registre à décalage**
Zelle für Schieberegister
Cell for shift register

(30) Priorité: 20.05.1994 FR 9406491
(43) Date de publication de la demande: 13.12.1995
(60) Demande divisionnaire: 97111252.9
(73) Titulaire: SGS-THOMSON MICROELECTRONICS S.A., 94250 Gentilly (FR)
(72) Inventeur: Odinot, Charles, F-57000 Metz (FR)
(74) Mandataire: Schmit, Christian Norbert Marie

(56) Documents cités:
- EP-A- 0 578 540
- US-A- 4 872 137
- US-A- 4 970 690
- US-A- 5 202 625
- US-A- 5 220 281

## Description

La présente invention concerne une cellule pour registre à décalage. Elle trouve un intérêt tout particulier dans la mise en oeuvre de tests de fonctionnement de circuits intégrés spécialisés.

Les circuits intégrés spécialisés, ou ASIC (de l'anglais "Application Specific Integrated Circuit") sont des circuits intégrés réalisés sur une puce unique à la demande de l'utilisateur. Certains circuits intégrés spécialisés comprennent une unité centrale (par exemple un processeur de traitement de signal, ou DSP, dans le cas d'un circuit intégré dédié au traitement du signal) associée à un certain nombre de dispositifs dépendant de l'application du circuit : mémoires, interfaces...

L'utilisateur fournit au fabricant le programme d'application du circuit et des informations sur la configuration de circuit souhaitée telles que le type et le volume des mémoires ou la nature des dispositifs d'interface du circuit. Le circuit intégré est alors réalisé sur une puce en associant à l'unité centrale les dispositifs spécifiés, notamment une mémoire morte (ROM) contenant le programme d'application.

Pour le test du fabricant, il est connu de faire exécuter par l'unité centrale un programme de test automatique stocké dans la mémoire de programmes du circuit. Comme les configurations dépendent de la demande de l'utilisateur, il n'est pas possible de prévoir un programme de test unique.

Pour tester des circuits intégrés, il est également connu par exemple d'après EP - 0 358 376, d'utiliser un registre à décalage formé en reliant en série un ensemble de cellules élémentaires montées sur les lignes d'entrée/sortie du circuit intégré. Chaque cellule peut injecter sur sa ligne respective une valeur introduite en série à travers le registre à décalage, et échantillonner la valeur du signal véhiculé par cette ligne en vue d'une lecture en série à travers le registre à décalage. On peut ainsi injecter des signaux de test dans le circuit intégré et contrôler le comportement du circuit en réponse à ces signaux.

Un inconvénient de ce système est de ne pas permettre un accès directement aux bus internes du circuit servant aux communications entre l'unité centrale et les dispositifs dépendants de l'application, à moins d'augmenter considérablement le nombre de cellules, ce qui nuit à la compacité du circuit, et à la rapidité du registre à décalage.

Il est également connu, par exemple d'après EP - 0 578 540, d'utiliser un registre à décalage formé en reliant des cellules montées sur les lignes d'entrée/sortie de l'unité centrale. Cela permet de tester à la fois l'unité centrale, et les dispositifs associés, avec un nombre de cellules restreint. Elle permet également de tester un grand nombre de configurations possibles sans modifier le registre à décalage.

Typiquement, une cellule utilisée pour prendre place dans un registre à décalage est montée en série sur une ligne (une ligne d'accès à une unité centrale par exemple) et en série avec d'autres cellules connectées à d'autres lignes. Physiquement, la dite ligne sera donc séparée en deux parties. Par exemple, si une telle cellule est montée sur une ligne d'un bus entre une unité centrale et un périphérique, une partie de la ligne ira de l'unité centrale à la cellule, et l'autre partie de la ligne ira de la cellule au périphérique. Une telle cellule comprend donc une entrée, dite parallèle, connectée à une partie de la ligne, une sortie, dite parallèle, connectée à l'autre partie de la ligne (pour injecter sur cette partie de la ligne une valeur transmise de l'extérieur via les autres cellules ou pour fournir la valeur présente sur l'entrée parallèle auquel cas la cellule est transparente), une entrée série, et une sortie série pour permettre de décaler progressivement, dans le registre à décalage dans lequel cette cellule prend place, les valeurs à injecter ou les valeurs échantillonnées.

On voit donc que les cellules pourront être unidirectionnelles si elles sont montées sur des lignes ayant un sens défini de propagation de signal, ou bidirectionnelles si elles sont montées sur des lignes servant à transmettre des signaux dans les deux sens, auquel cas les entrées et sorties parallèles sont en fait des entrée/sortie.

Typiquement, les cellules unidirectionnelles comportent une bascule de mémorisation (par exemple une bascule à retard de type maître-esclave) pouvant recevoir en entrée soit la valeur du signal présent sur l'entrée parallèle (dans le cas d'un échantillonnage), soit sur l'entrée série (dans le cas d'une injection ou d'un décalage), et dont la sortie est connectée à la sortie série (pour permettre le décalage d'une cellule à l'autre). D'autre part, elles comportent aussi classiquement un multiplexeur ayant une entrée connectée à l'entrée parallèle, et une entrée connectée à la sortie de la bascule de mémorisation, éventuellement par le biais d'une bascule à verrouillage, et une sortie connectée à la sortie parallèle, ce multiplexeur permettant d'injecter sur la ligne une valeur, ou de rendre la cellule transparente à la ligne (l'entrée et la sortie parallèles étant alors reliées). Ces différents moyens sont commandés par des signaux de commande provenant soit d'un bloc de contrôle externe, soit d'un bloc de contrôle interne recevant des signaux de commande externes, les procédures de test étant bien sûr pilotés de l'extérieur du circuit.

Dans le cas des cellules bidirectionnelles, la composition des cellules est identique, si ce n'est qu'elles comportent un multiplexeur supplémentaire ayant une entrée connectée à la sortie parallèle (qui se comporte en entrée/sortie), une entrée connectée à la sortie de la bascule de mémorisation (éventuellement par le biais d'une bascule à verrouillage), et une sortie connectée à l'entrée parallèle qui se comporte en entrée/sortie) . D'autre part, il est nécessaire de prévoir une commande et une entrée supplémentaire sur les moyens de multiplexage nécessaires pour pouvoir fournir à l'entrée de la bascule de mémorisation soit la valeur du signal présent à l'entrée série (en cas de décalage) soit la valeur d'un des signaux présents sur les entrée et sortie parallèles (en cas d'échantillonnage).

Le document US-A-5 220 281 dévoile une cellule de type bidirectionnelle classiquement utilisée. La cellule dévoilée est mise en série sur une ligne de transmission, introduisant un interrupteur sur la ligne de transmission.

Les cellules classiquement utilisées présentent plusieurs inconvénients :
- elles induisent des retards dans la propagation d'un signal sur la ligne, de l'ordre de 0,5 à 2 nanosecondes, selon la technologie employée, du fait de la traversée d'au moins un multiplexeur,
- elles posent un problème de synchronisation dans la mesure où les signaux présents sur les lignes dépendent d'horloges internes au circuit, alors que les signaux de commande d'un registre à décalage utilisés pour décaler des valeurs échantillonnées dépendent d'une horloge externe au circuit, puisqu'en pratique, les valeurs à injecter ou les valeurs échantillonnées sont fournies par, ou à des dispositifs de test externes aux circuits à tester. Cela oblige donc soit à produire des signaux de commande de décalage, à partir de signaux externes au circuit, qui soient synchronisés avec les signaux d'horloge internes, soit à arrêter les signaux d'horloge internes de manière à garantir la stabilité des valeurs des signaux présents sur les lignes au moment où ou souhaite les échantillonner. La première solution a l'inconvénient de nécessiter des ressources supplémentaires, et donc d'augmenter la taille et la consommation des circuits, et la deuxième solution a l'inconvénient de nécessiter d'interrompre le fonctionnement du circuit à chaque échantillonnage.
- elles ne garantissent pas l'état logique interne de la cellule, par exemple le signal présent sur la sortie de la bascule de mémorisation où d'éventuelles fuites peuvent éventuellement dégrader ce signal, aucun rebouclage n'étant prévu pour le maintenir,
- elles posent un problème de consommation au niveau de l'entrée des bascules de mémorisation ou à verrouillage, quand celles-ci sont bloquées (entrée isolée de la sortie), car elles sont alors isolées et peuvent être sujettes à des fuites de type capacitives ou dynamiques au niveau par exemple de substrats de transistors d'entrée.

Au vu de ce qui précède, un but de la présente invention est de proposer une cellule qui n'induise pas de retard sur la ligne à laquelle est connectée.

L'invention propose ainsi un dispositif pour circuit intégré, comportant une ligne de transmission et une cellule pour registre à décalage, destinée à tester par injection sur la ligne de transmission d'une valeur binaire, ou par échantillonnage de la valeur du signal présent sur la dite ligne, cette cellule comprenant :
- une entrée parallèle connectée à la ligne pour recevoir un signal d'entrée parallèle,
- une sortie parallèle connectée à la ligne pour fournir un signal de sortie parallèle,
- une entrée série pour recevoir un signal d'entrée série à décaler dans une cellule suivante ou à injecter sur la ligne,
- une sortie série pour fournir un signal de sortie série à une entrée série d'une cellule suivante,
l'entrée parallèle et la sortie parallèle étant reliées, la cellule étant montée parallèlement à la ligne de transmission, et la sortie parallèle étant connectée à la sortie d'un circuit tampon trois états, caractérisé en ce que la ligne de transmission est connectée à une unique cellule qui comporte une unique entrée parallèle et une unique sortie parallèle reliées à ladite ligne de transmission.

Ainsi, dans l'invention, on prévoit de réaliser une cellule montée en parallèle sur sa ligne et munie de moyens pour isoler la sortie parallèle de la cellule de manière à ce que le signal présent sur la ligne puisse éventuellement évoluer indépendamment de la cellule.

Un autre but de l'invention est de proposer une cellule qui ait des capacités de mémorisation, de façon à pouvoir échantillonner la valeur du signal présent sur la ligne sans arrêter le fonctionnement du circuit, et sans obliger à synchroniser les horloges de décalage externes avec les horloges internes du circuit.

Dans une version préférée, la cellule comprendra une bascule à verrouillage ayant une entrée recevant le signal d'entrée parallèle.

Un autre but de l'invention est de proposer une cellule qui permettra de garantir l'état des signaux présents en entrée et en sortie des bascules de la cellule, et par la suite de minimiser la consommation de cette cellule.

Avantageusement l'entrée de la bascule à verrouillage sera connectée à la sortie d'un multiplexeur, ce multiplexeur ayant une entrée connectée à l'entrée parallèle et une entrée connectée à la sortie de la bascule à verrouillage.

D'autres particularités et avantages apparaîtront dans la description ci-après, d'exemples de réalisation préférés et non limitatifs, lue conjointement aux dessins annexés, dans lesquels :
- la figure 1 est un schéma d'un circuit intégré mettant en oeuvre un registre à décalage,
- la figure 2 est un schéma d'une cellule montée en parallèle sur une ligne et réalisée conformément a l'invention.

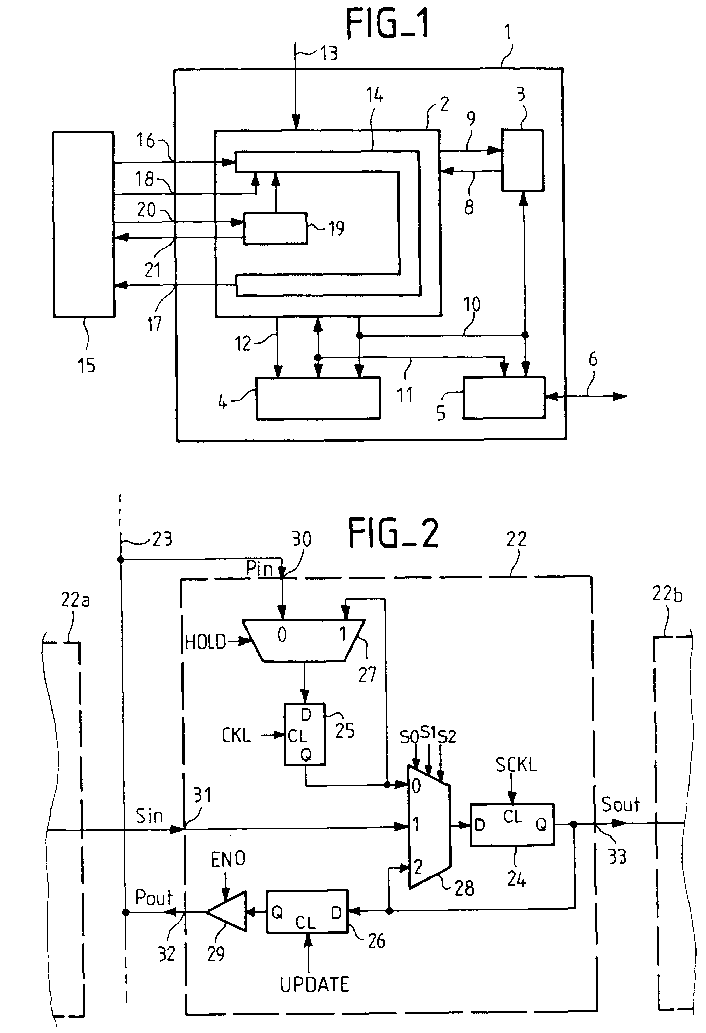

En référence à la figure 1, un circuit intégré 1, réalisé sur une puce de silicium par exemple, comporte une unité centrale 2 et un certain nombre de dispositifs 3, 4, 5 dépendants de l'application du circuit intégré. Les dispositifs associés à l'unité centrale 2 comprennent par exemple une mémoire de programme 3 à lecture seule (ROM), une mémoire de données 4 à accès aléatoire (RAM) et un ou plusieurs dispositifs d'interface schématisés par l'unité 5. Ces dispositifs d'interface sont reliés à des accès primaires 6 du circuit 1 permettant d'échanger des signaux analogiques ou numériques avec l'environnement du circuit 1.

L'unité centrale est reliée à la mémoire de programmes 3 de façon classique, par un bus d'instructions 8, un bus d'adresse d'instructions 9 et des lignes d'un bus de sortie de commandes 10 permettant de lire des instructions de programme dans la mémoire 3 en vue de leur exécution. De même, l'unité centrale 2 est reliée aux dispositifs 4, 5 par un bus de données bidirectionnel 11, un bus d'adresses de données 12 et des lignes du bus de sortie de commandes 10, permettant à l'unité centrale 2 d'échanger des données (émission ou réception) avec les dispositifs 4, 5. L'unité centrale 2 pourra comprendre aussi un bus d'entrée de commande 13 permettant de recevoir des signaux de commande extérieurs.

Dans l'exemple d'application décrit, l'unité centrale 2 est munie d'un registre à décalage 14. Ce registre à décalage 14, du type "boundary scan" (voir EP A 0 358 376), comprend un ensemble de cellules élémentaires reliées en série et montées chacune sur une ligne respective véhiculant un signal binaire du circuit intégré 1. Plus précisément, les cellules sont montées sur des lignes correspondant à des accès à l'unité centrale 2 : bus d'instructions 8, bus d'entrée de commande 13, bus de données 11, bus d'adresses d'instructions 9, etc.

Pour tester le circuit intégré 1, on le relie à un dispositif de test 15. Pour réaliser cette liaison, le circuit 1 comporte :
- une borne 16 qui correspond à l'entrée de données série du registre à décalage 14,
- une borne 17 qui correspond à la sortie de données série du registre à décalage 14,
- des bornes désignées collectivement par la référence 18 pour adresser à l'ensemble des cellules du registre à décalage 14 des signaux de commande,
- des bornes désignées collectivement par la référence 20, pour adresser à une unité de commande 19 des signaux binaires de sélection, et
- des bornes désignées collectivement par la référence 21, pour lesquelles l'unité de commande de test 21 peut adresser des signaux binaires au dispositif de test 15.

On ne décrira pas plus avant le circuit 1, étant donné qu'il schématise un exemple d'utilisation de registre à décalage. on pourra se reporter pour de plus amples détails par exemple à EP 0 578 540 qui décrit en détail une unité centrale telle que décrite ci-dessus.

On peut classer les cellules élémentaires d'un registre à décalage en trois types :
- premièrement, des cellules dites de type bus, illustrées par la figure 2, destinées à être reliées à des lignes bidirectionnelles ou unidirectionnelles, telles que celles du bus de données bidirectionnelles 11 ou du bus d'adresse d'instruction 9, et placées en parallèle par rapport à ces lignes,
- deuxièmement, des cellules dites de type unidirectionnel destinées à être reliées à des lignes unidirectionnelles, telles que celles du bus d'adresses d'instructions 9, et placées en série sur ces lignes,
- troisièmement, des cellules dites de type bidirectionnel destinées à être reliées à des lignes bidirectionnelles, comme dans le cas des cellules de type bus, mais placées en série sur ces lignes, de manière analogue aux cellules unidirectionnelles.

Les cellules de type unidirectionnel et bidirectionnel sont connues dans leur principe. La cellule de type bus est l'objet principal de cet invention.

La figure 2 illustre une cellule de type bus 22, montée en parallèle sur une ligne 23, par exemple une ligne d'accès à l'unité centrale 2. Cette cellule 22 comprend une bascule de mémorisation 24 (par exemple du type à retard maître-esclave), une première bascule à verrouillage 25, une deuxième bascule à verrouillage 26, un premier multiplexeur 27 à deux entrées, un second multiplexeur 28 à trois entrées, et un circuit tampon trois états 29 (en anglais "tristate buffer").

Une entrée parallèle 30 de la cellule 22 reçoit le signal binaire Pin véhiculé par la ligne 23. Cette entrée 30 est reliée à une entrée 0 du premier multiplexeur 27.

Une entrée série 31 reçoit un signal binaire Sin issu de la cellule précédente 22a du registre à décalage 14 ou de la borne 16 d'entrée du registre à décalage 14. Cette entrée série 31 est reliée à une entrée 1 du second multiplexeur 28.

Une sortie parallèle 32 est reliée à la ligne 23 et permet d'injecter une valeur sur cette ligne. On notera Pout le signal présent sur cette sortie parallèle.

Une sortie série 33 est connectée à l'entrée série de la cellule 22b suivante, ou à la borne 17 de sortie du registre 14 si c'est la dernière cellule du registre. On appellera Sout le signal présent sur la sortie série 33.

Le premier multiplexeur 27 a une sortie connectée à l'entrée de la première bascule à verrouillage 25. Cette bascule 25 a sa sortie connectée d'une part à une entrée 0 du second multiplexeur 28 et d'autre part à une deuxième entrée 1 du premier multiplexeur 27.

Le second multiplexeur 28 a une sortie connectée à l'entrée de la bascule de mémorisation 24. Cette bascule 24 a sa sortie connectée à la sortie série 33, à une entrée 2 du second multiplexeur 28 et à l'entrée de la seconde bascule à verrouillage 26.

La seconde bascule à verrouillage 26 a sa sortie connectée à l'entrée du circuit tampon trois états 29, circuit tampon dont la sortie est connectée à la sortie parallèle 32.

Le premier multiplexeur 27 reçoit une commande logique HOLD permettant de relier sélectivement l'entrée de la première bascule à verrouillage 25 à l'entrée parallèle 30, ou à la sortie de cette même bascule. Ainsi, si HOLD = 0, on pourra échantillonner la valeur du signal Pin présent sur la ligne 23 dans la bascule à verrouillage 25. Si HOLD = 1, on maintiendra les états de l'entrée et de la sortie de cette bascule dans un état stable permanent.

La première bascule à verrouillage 25 reçoit un signal logique de commande CKL de manière à verrouiller, sur sa sortie, la valeur du signal présent à son entrée, sur front descendant de CKL par exemple.

En pratique, les circuits intégrés ont leur fonctionnement synchronisé par un signal d'horloge de base CLOCK, réalisé par exemple à l'aide d'un quartz ou d'un circuit oscillant. Tous les changements d'états logiques sur les lignes (bus de donnée, d'adresse, etc) produits par des dispositifs internes à de tels circuits ne sont susceptibles de se produire que sur des fronts montants ou descendants de ce type d'horloge. De ce fait, on pourra toujours savoir si un changement d'état sur une ligne donnée et produit par un dispositif interne, ne peut se produire que sur front descendant, ou que sur front montant, de ce signal d'horloge de base CLOCK.

Si on souhaite être sûr de la stabilité de la valeur du signal Pin au moment où on la mémorise dans la première bascule à verrouillage 25, il suffira de choisir un signal CKL tel que (dans l'hypothèse d'un verrouillage sur front descendant de CKL) :
- CKL = CLOCK si Pin ne peut changer d'état que sur front montant de CLOCK,
- CKL = /CLOCK si Pin ne peut changer d'état que sur front descendant de CLOCK.

D'autre part, dans le premier (ou second) cas, on choisira un signal HOLD qui passe à 0 par exemple sur front montant (ou descendant) de CLOCK et remonte à 1 sur le front montant (ou descendant) suivant de CLOCK.

Pour permettre un échantillonnage de la valeur du signal Pin, il n'est pas nécessaire que le signal logique CKL oscille lui-même au rythme de l'horloge de base. Il suffit qu'on soit sûr qu'au moment où on souhaite échantillonner, la valeur du signal Pin ne puisse pas changer. On pourra, suivant les lignes, fournir aux cellules des signaux de commande de première bascule de verrouillage qui soient différents et adaptés au type de front sur lequel un changement d'état peut se produire sur ces lignes.

Ce montage a trois avantages :
- on peut échantillonner les valeurs des signaux présents sur les lignes sans arrêter le fonctionnement du circuit pour figer l'état de ces signaux,
- les valeurs échantillonnées sont mémorisées dans la bascule à verrouillage sans risque de dérive, puisque, quel que soit l'état du signal de commande CKL, quand l'entrée de la bascule à verrouillage 25 est isolée de l'entrée parallèle 30 (HOLD = 1), l'entrée et la sortie de la bascule sont dans un même état stable. On peut donc récupérer, par le biais du registre à décalage 14, les valeurs échantillonnées, au moment où on le souhaite, et on évite les risques de consommation accrue du fait des fuites possibles à l'entrée de la bascule à verrouillage 25 puisque son état est stable et non flottant.

Le second multiplexeur 28 reçoit trois signaux de commande logiques S0, S1, S2 pour fournir sélectivement sur la sortie de ce multiplexeur, soit le signal présent en sortie de la première bascule de verrouillage 25, soit le signal présent sur l'entrée série 31, soit le signal présent sur la sortie série 33. On supposera que ces signaux permettent de relier l'entrée qui leur correspond à la sortie s'ils sont à 1, un seul signal étant bien sûr à 1 à la fois.

Ainsi :
- si S0 = 1, alors on pourra transférer la valeur du signal fourni par la première bascule à verrouillage dans la bascule de mémorisation 24 et procéder ainsi au transfert de la valeur échantillonnée sur la ligne 23 dans la cellule suivante 22b,
- si S1 = 1, alors on pourra transférer dans la bascule de mémorisation 24 la valeur d'un signal fourni par la sortie série de la cellule précédente 22a pour la fournir à la cellule suivante (en phase de décalage dans le registre) ou l'injecter sur la ligne 23,
- Si S2 = 1, alors on maintient un état logique stable à l'entrée de la bascule de mémorisation, cet état étant identique à l'état présent sur la sortie de cette bascule. On choisira judicieusement S2 = 1 comme valeur par défaut pour la commande du second multiplexeur 28, quant le registre n'est pas utilisé pour injecter des données ou pour récupérer des données échantillonnées.

De même que dans le cas de la première bascule à verrouillage, on évite ainsi la présence d'un noeud flottant à l'entrée de la bascule de mémorisation, susceptible d'entraîner une consommation due, par exemple, à des fuites de type capacitive au niveau de transistors d'entrée de cette bascule.

La bascule 24 est cadencée par un signal de commande logique SCKL. Typiquement, ce signal sera fourni par le dispositif de test 16 pour contrôler le décalage dans le registre à décalage. Les signaux de commande HOLD et CLK seront plutôt fournis par l'unité de commande 19 dans la mesure où ils doivent être synchrones avec l'horloge de base interne du circuit intégré pour permettre un échantillonnage satisfaisant. De même que pour le signal SCKL, les signaux S0, S1 et S2 seront de préférence fournis par le dispositif de test 16 si on souhaite minimiser la taille de l'unité de commande 19. Si on souhaite par contre minimiser le nombre de broches nécessaires à la communication entre cette unité et le dispositif de test, on choisira avantageusement de les produire de manière interne au circuit.

La seconde bascule à verrouillage 26 reçoit un signal de commande logique UPDATE pour verrouiller sur sa sortie, l'état du signal présent à son entrée, sur front descendant de UPDATE par exemple. De même que pour les autres bascules, l'état de l'entrée de la seconde bascule à verrouillage 26 sera toujours stable, quel que soit l'état du signal de commande UPDATE, si S2 = 1. On évite ainsi d'éventuelles fuites qui seraient possibles si l'état de cette entrée était flottant.

Le circuit tampon trois état 29 reçoit un signal de commande logique ENO. On pourra par exemple réaliser ce circuit en connectant en série deux inverseurs trois états de telle manière que le second soit passant si ENO = 1 et en haute impédance si EN0 = 0. Il est nécessaire d'utiliser un circuit logique trois états pour que le signal présent sur la ligne 23 puisse changer quand on ne souhaite pas injecter sur cette ligne une valeur donnée.

Typiquement, le signal de commande ENO pourra être fourni par le dispositif de test 19 de manière à ce qu'il soit synchronisé avec le signal SCKL qui cadence le décalage dans le registre.

La cellule telle que décrite ci-dessus présente donc les avantages suivants :
- elle peut être montée en parallèle sur des lignes aussi bien unidirectionnelles que bidirectionnelles,
- elle n'induit pas de retard de transmission des signaux présents sur la ligne 23,
- elle permet un échantillonnage sans arrêter le fonctionnement du circuit et indépendamment de l'état du signal de commande de décalage SCKL par rapport au signal d'horloge interne CLOCK,
- elle minimise la consommation des cellules en maintenant les entrées des différents bascules dans des états non flottants quand celles-ci sont isolées des entrées de la cellule.

On pourrait bien sûr imaginer des cellules du type bus moins volumineuses, par exemple en :
- connectant directement l'entrée parallèle 30 à l'entrée 0 du second multiplexeur, moyennant quoi on serait obligé de synchroniser le signal de commande SCKL avec l'horloge interne CLOCK ou d'arrêter le fonctionnement du circuit pour s'assurer de la stabilité du signal sur la ligne 23 quand on souhaite échantillonner sa valeur,
- se contentant de connecter l'entrée parallèle 30 à l'entrée de la première bascule à verrouillage 25, celle-ci étant commandée par le signal de commande HOLD, évitant ainsi les inconvénients précédents mais en acceptant l'éventualité d'une consommation supplémentaire due à d'éventuelles fuites au niveau des transistors d'entrée de cette bascule quand le signal présent sur la ligne varie,
- se contentant d'un deuxième multiplexeur à deux entrées, en ne rebouclant pas la sortie de la bascule de mémorisation sur son entrée, avec les inconvénients précédemment cités.

Bien que l'on ait décrit l'invention en référence à un exemple de réalisation préféré, on comprendra que cet exemple n'est pas limitatif et que diverses modifications peuvent leur être apportées sans sortir du cadre de l'invention. Ainsi, bien qu'on ait décrit un exemple de circuit intégré comprenant un registre de décalage formé au niveau des entrées/sorties de l'unité centrale, on pourra très bien utiliser les cellules décrites précédemment pour un circuit intégré dans lequel on forme un registre à décalage sur les entrées/sorties du circuit.

## Revendications

1. Dispositif pour circuit intégré, comportant une ligne de transmission (23) et une cellule (22) pour registre à décalage (14), destinée à tester par injection sur la ligne de transmission (23) d' une valeur binaire, ou par échantillonnage de la valeur du signal présent sur ladite ligne (23), cette cellule (22) comprenant :
- une entrée parallèle (30) connectée à la ligne (23) pour recevoir un signal d'entrée parallèle (Pin),
- une sortie parallèle (32) connectée à la ligne (23) pour fournir un signal de sortie parallèle (Pout),
- une entrée série (31) pour recevoir un signal d'entrée série (Sin) à décaler dans une cellule suivante (22b) ou à injecter sur la ligne (23),
- une sortie série (33) pour fournir un signal de sortie série (Sout) à une entrée série d'une cellule suivante (22b),
- l'entrée parallèle (30) et la sortie parallèle (32) étant reliées, la cellule (22) étant montée parallèlement à la ligne de transmission (23), et la sortie parallèle (32) étant connectée à la sortie d'un circuit tampon trois états (29), caractérisé en ce que la ligne de transmission (23) est connectée à une unique cellule (22) qui comporte une unique entrée parallèle (30) et une unique sortie parallèle (32) reliées à ladite ligne de transmission (23).

2. Dispositif selon la revendication 1, caractérisé en ce que la cellule (22) comprend un premier multiplexeur (28) recevant sur une première entrée le signal d'entrée parallèle (Pin) et sur une deuxième entrée le signal d'entrée série (Sin), ce premier multiplexeur (28) ayant une sortie connectée à l'entrée d'une bascule de mémorisation (24).

3. Dispositif selon la revendication 2, caractérisé en ce que l'entrée parallèle (30) est connectée à l'entrée d'une bascule à verrouillage (25) dont la sortie est connectée à la première entrée du premier multiplexeur (28).

4. Dispositif selon la revendication 2, caractérisé en ce que l'entrée parallèle (30) est connectée à une première entrée d'un second multiplexeur (27), ce second multiplexeur ayant une sortie connectée à l'entrée d'une bascule à verrouillage (25), la sortie de cette bascule à verrouillage étant connectée d'une part à la première entrée du premier multiplexeur (28), et d'autre part à une deuxième entrée du second multiplexeur (27).

5. Dispositif selon l'une des revendications 2 à 4, caractérisé en ce que la sortie série (33) est connectée d'une part à la sortie de la bascule de mémorisation (24) et d'autre part à une troisième entrée du premier multiplexeur (28).

6. Dispositif selon l'une des revendications 2 à 5, caractérisé en ce que le circuit tampon trois états (29) a une entrée connectée à la sortie de la bascule de mémorisation (24) et une sortie connectée à la sortie parallèle (32).

7. Dispositif selon l'une des revendications 2 à 5, caractérisé en ce que le circuit tampon trois états (29) a une entrée connectée à la sortie d'une deuxième bascule à verrouillage (26), cette deuxième bascule à verrouillage ayant une entrée connectée à la sortie de la bascule de mémorisation (24), et le circuit tampon ayant une sortie connectée à la sortie parallèle (32).

8. Dispositif selon l'une des revendications 2 à 7, caractérisé en ce que la bascule de mémorisation (24) est du type bascule à retard maître-esclave.

9. Dispositif selon l'une des revendications 1 à 8, caractérisé en ce que le signal d'entrée série (Sin) provient de la sortie série d'une cellule précédente (22a) qui est connectée à une deuxième ligne de transmission, et en ce que la cellule suivante (22b) est connectée à une troisième ligne de transmission et en ce que la ligne de transmission, la deuxième ligne de transmission et la troisième ligne de transmission sont des lignes distinctes.

## Patentansprüche

1. Vorrichtung für einen integrierten Schaltkreis, die eine Übertragungsleitung (23) und eine Zelle (22) für ein Schieberegister (14) aufweist, die durch Einspeisen eines Binärwerts auf die Übertragungsleitung (23) oder durch Abtastung des Werts des auf dieser Leitung (23) vorhandenen Signals testen soll, wobei diese Zelle (22) aufweist:
- einen parallelen Eingang (30), der mit der Leitung (23) verbunden ist, um ein paralleles Eingangssignal (Pin) zu empfangen,
- einen parallelen Ausgang (32), der mit der Leitung (23) verbunden ist, um ein paralleles Ausgangssignal (Pout) zu liefern,
- einen Serien-Eingang (31), um ein Serien-Eingangssignal (Sin) zu empfangen, das in eine folgende Zelle (22b) verschoben oder auf die Leitung (23) übertragen werden soll,
- einen Serien-Ausgang (33), um ein Serien-Ausgangssignal (Sou) an einem Serien-Eingang einer folgenden Zelle (22b) zu liefern,
- wobei der parallele Eingang (30) und der parallele Ausgang (32) verbunden sind, wobei die Zelle (22) zur Übertragungsleitung (23) parallelgeschaltet und der parallele Ausgang (32) mit dem Ausgang einer Pufferschaltung (29) mit drei Zuständen verbunden ist, dadurch gekennzeichnet, daß die Übertragungsleitung (23) mit einer einzigen Zelle (22) verbunden ist, die einen einzigen parallelen Eingang (30) und einen einzigen parallelen Ausgang (32) besitzt, die mit der Übertragungsleitung verbunden (23) sind.

2. Vorrichtung nach Anspruch 1, dadurch gekennzeichnet, daß die Zelle (22) einen ersten Multiplexer (28) aufweist, der an einem ersten Eingang das parallele Eingangssignal (Pin) und an einem zweiten Eingang das Serien-Eingangssignal (Sin) empfängt, wobei ein Ausgang dieses ersten Multiplexers (28) mit dem Eingang einer Speicher-Kippstufe (24) verbunden ist.

3. Vorrichtung nach Anspruch 2, dadurch gekennzeichnet, daß der parallele Eingang (30) mit dem Eingang einer Verriegelungs-Kippstufe (25) verbunden ist, deren Ausgang mit dem ersten Eingang des ersten Multiplexers (28) verbunden ist.

4. Vorrichtung nach Anspruch 2, dadurch gekennzeichnet, daß der parallele Eingang (30) mit einem ersten Eingang eines zweiten Multiplexers (27) verbunden ist, daß ein Ausgang dieses zweiten Multiplexers mit dem Eingang einer Verriegelungs-Kippstufe (25) verbunden ist, während der Ausgang dieser Verriegelungs-Kippstufe einerseits mit dem ersten Eingang des ersten Multiplexers (28) und andererseits mit einem zweiten Eingang des zweiten Multiplexers (27) verbunden ist.

5. Vorrichtung nach einem der Ansprüche 2 bis 4, dadurch gekennzeichnet, daß der Serien-Ausgang (33) einerseits mit dem Ausgang der Speicher-Kippstufe (24) und andererseits mit einem dritten Eingang des ersten Multiplexers (28) verbunden ist.

6. Vorrichtung nach einem der Ansprüche 2 bis 5, dadurch gekennzeichnet, daß ein Eingang der Pufferschaltung (29) mit drei Zuständen mit dem Ausgang der Speicher-Kippstufe (24) und ein Ausgang mit dem parallelen Ausgang (32) verbunden ist.

7. Vorrichtung nach einem der Ansprüche 2 bis 5, dadurch gekennzeichnet, daß ein Eingang der Pufferschaltung (29) mit drei Zuständen mit dem Ausgang einer zweiten Verriegelungs-Kippstufe (26) verbunden ist, daß ein Eingang dieser zweiten Verriegelungs-Kippstufe mit dem Ausgang der Speicher-Kippstufe (24) verbunden ist, und daß ein Ausgang der Pufferschaltung mit dem parallelen Ausgang (32) verbunden ist.

8. Vorrichtung nach einem der Ansprüche 2 bis 7, dadurch gekennzeichnet, daß die Speicher-Kippstufe (24) von der Art einer Master-Slave-Verzögerungs-Kippstufe ist.

9. Vorrichtung nach einem der Ansprüche 1 bis 8, dadurch gekennzeichnet, daß das Serien-Eingangssignal (Sin) vom Serien-Ausgang einer vorhergehenden Zelle (22a) kommt, die mit einer zweiten Übertragungsleitung verbunden ist, und daß die folgende Zelle (22b) mit einer dritten Übertragungsleitung verbunden ist, und daß die Übertragungsleitung, die zweite Übertragungsleitung und die dritte Übertragungsleitung unterschiedliche Leitungen sind.

## Claims

1. Device for an integrated circuit, including a transmission line (23) and a cell (22) for a shift register (14), designed for testing by injecting a binary value onto the transmission line (23), or by sampling the value of the signal present on the said line (23), this cell (22) comprising:
- a parallel input (30) connected to the line (23) for receiving a parallel input signal (Pin).
- a parallel output (32) connected to the line (23) for supplying a parallel output signal (Pout),
- a serial input (31) for receiving a serial input signal (Sin) to be shifted into a following cell (22b) or to be injected onto the line (23),
- a serial output (33) for supplying a serial output signal (Sout) to a serial input of a following cell (22b),
- the parallel input (30) and the parallel output (32) being connected, the cell (22) being mounted parallel to the transmission line (23), and the parallel output (32) being connected to the output of a three-state buffer circuit (29), characterised in that the transmission line (23) is connected to a single cell (22) which has a single parallel input (30) and a single parallel output (32) connected to the said transmission line (23).

2. Device according to Claim 1, characterised in that the cell (22) comprises a first multiplexer (28) receiving the parallel input signal (Pin) at a first input and the serial input signal (Sin) at a second input, this first multiplexer ((28) having an output connected to the input of a storage flip-flop (24).

3. Device according to Claim 2, characterised in that the parallel input (30) is connected to the input of a latching flip-flop (25), the output of which is connected to the first input of the first multiplexer (28).

4. Device according to Claim 2, characterised in that the parallel input (30) is connected to a first input of a second multiplexer (27) this second multiplexer having an output connected to the input of a latching flip-flop (25), the output of this latching flip-flop being connected on the one hand to the first input of the first multiplexer (28) and on the other hand to a second input of the second multiplexer (25).

5. Device according to one of Claims 2 to 4, characterised in that the serial output (33) is connected on the one hand to the output of the storage flip-flop (24) and on the other hand to a third input of the first multiplexer (28).

6. Device according to one of Claims 2 to 5, characterised in that the three-state buffer circuit (29) has an input connected to the output of the storage flip-flop (24) and an output connected to the parallel output (32).

7. Device according to one of Claims 2 to 5, characterised in that the three-state buffer circuit (29) has an input connected to the output of a second latching flip-flop (26), this second latching flip-flop having an input connected to the output of the storage flip-flop (24), and the buffer circuit having an output connected to the parallel output (32).

8. Device according to one of Claims 2 to 7, characterised in that the storage flip-flop (24) is of the master-slave delay flip-flop type.

9. Device according to one of Claims 1 to 8, characterised in that the serial input signal (Sin) comes from the serial output of a preceding cell (22a) which is connected to a second transmission line, and in that the following cell (22b) is connected to a third transmission line and in that the transmission line, the second transmission line and the third transmission line are distinct lines.
